# FASCICULE DE BREVET EUROPEEN

(11) **EP 2 224 252 B1**
(45) Date de publication et mention de la délivrance du brevet: **28.09.2011**
(21) Numéro de dépôt: 10154365.0
(22) Date de dépôt: 23.02.2010
(51) Int. Cl.: G01R 15/16

(54) **Dispositif capacitif de mesure de la tension d'un élément haute tension**
Spannungsmessgerät für Hochspannungselement
Capacitive measuring devise for a high voltage element

(30) Priorité: 25.02.2009 FR 0951195
(43) Date de publication de la demande: 01.09.2010
(73) Titulaire: AREVA T&D AG, 5036 Oberentfelden (CH)
(72) Inventeur: Lüscher, Robert, 5703 SEON/AG (CH); Pohlink, Karsten, 5035, UNTERENTFELDEN (CH); Hiltbrunner, Hugo, 2824, VICQUES/JU (CH); Palmieri, Gerardo, 5036, OBERENTFELDEN/AG (CH)
(74) Mandataire: Ilgart, Jean-Christophe

(56) Documents cités:
- EP-A- 0 433 970
- EP-A- 0 984 289
- EP-A- 1 431 767
- US-A- 4 052 665

## Description

### DOMAINE TECHNIQUE

L'invention concerne un dispositif capacitif et un système de mesure de la tension d'un élément haute tension, et un poste électrique isolé au gaz mettant en oeuvre ce dispositif.

### ÉTAT DE LA TECHNIQUE ANTÉRIEURE

Le domaine de l'invention est celui de la mesure de tension d'éléments haute tension. Ce domaine est notamment celui de dispositifs capacitifs destinés à des appareillages électriques de type blindé, avec une isolation gazeuse comme par exemple de l'hexafluorure de soufre ou SF6.

Un tel dispositif peut ainsi être utilisé pour effectuer une mesure de la tension d'une barre, sur laquelle transite un courant, dans un poste électrique sous enveloppe métallique (PFEM) ou un poste électrique isolé au gaz (GIS). Un tel dispositif doit remplir les critères suivants : être simple et fiable, être produit à faible coût et ne nécessiter que peu de place, comporter deux canaux pouvant fonctionner indépendamment pour créer une redondance. De plus, les caractéristiques de ce dispositif, et notamment son taux de transmission, doivent être ajustables aisément afin d'obtenir des tensions et des courants de sortie dans une gamme donnée pour des conditions de fonctionnement différentes de l'application.

Dans une application typique, un tel dispositif peut être connecté à un équipement de contrôle ou d'indication visuelle par un câble de plusieurs mètres de longueur, en fonction de la situation locale. Si le conducteur haute tension est à une tension nominale, la tension de signal au niveau de l'équipement de contrôle ou d'indication visuelle peut être comprise entre 4 volts et 100 volts. Le dispositif peut alors être considéré comme un transformateur de tension, la tension en sortie étant influencée principalement par :
- la tension nominale appliquée (par exemple de 75 kV ou 145 kV),
- la situation géométrique à proximité du dispositif (influences du champ électrique),
- le type et la longueur de câble (influences des capacités secondaires).

Dans une autre situation typique, le dispositif est connecté à un affichage à diodes électroluminescentes (DEL) par un câble court. Si le conducteur haute tension est à une tension nominale le courant de signal au niveau de l'affichage atteint 0,5 microampère à 3 microampères. Le capteur peut alors être considéré comme une source de courant, le courant étant influencé par :
- la tension nominale du poste électrique isolé au gaz GIS (par exemple 75 kV ou 145 kV),
- la situation géométrique à proximité du dispositif (influence du champ électrique).

On va à présent analyser deux documents de l'art connu.

Le document référencé [1] en fin de description décrit un dispositif capacitif de mesure de haute précision qui comporte un condensateur à haute stabilité thermique pour poste blindé haute tension. Ce condensateur comporte une électrode haute tension alongée, un circuit imprimé cylindrique entourant coaxialement cette électrode haute tension et comportant une piste électriquement conductrice formant une électrode basse tension, et un châssis définissant une surface interne cylindrique entourant coaxialement le circuit imprimé cylindrique. Le circuit imprimé est fendu le long d'une génératrice du cylindre ainsi formé, et deux anneaux sont fixés le long de la surface interne pour former deux gorges circulaires se faisant face. Le circuit imprimé est emboîté dans ces gorges, et les anneaux exercent un effort radial qui cintre les génératrices du circuit imprimé pour le maintenir plaqué contre la surface interne.

Ce dispositif est prévu pour être ajouté à un dispositif de commutation monophasé encapsulé. Mais ce dispositif nécessite une place importante, et présente un coût élevé. De plus, une adaptation simple du rapport de transmission n'est pas possible.

Le document référencé [2] en fin de description décrit un dispositif capacitif de mesure de décharge partielle pour un poste isolé au gaz, dans une enceinte métallique, qui comprend un conducteur haute tension. Ce dispositif comporte une antenne dipolaire de réception de signal, de forme circulaire comprenant deux éléments d'électrodes conductrices en forme de plaques semi-circulaires disposée dans un évidement de l'encapsulage, une première capacité électrostatique étant formée entre cette antenne et le conducteur haute tension, une seconde capacité électrostatique étant formée entre cette antenne et la terre, un câble coaxial couplé à ladite antenne permettant une connexion à une unité de mesure, et une unité de mesure couplée audit câble coaxial.

Dans ce dispositif, la première capacité électrostatique n'est pas adaptée pour fournir un courant suffisamment élevé pour faire fonctionner un indicateur sans alimentation de puissance externe, ou pour avoir des niveaux de signal de sortie identiques pour des conditions d'application spécifique différentes. La connexion du câble coaxial au milieu des électrodes rend impossible une application de ce dispositif dans un commutateur de mise à la terre. De plus, ce dispositif ne prévoit pas de systèmes redondants.

L'objet de l'invention est d'obtenir un dispositif capacitif de mesure adaptable aux conditions d'application définies ci-dessus, le signal de sortie devant se situer dans une gamme de valeurs indépendante des conditions de fonctionnement de l'application, ce dispositif pouvant être utilisé dans différents emplacements d'un poste isolé au gaz (GIS), par exemple dans un commutateur de mise en terre. Ce dispositif doit, de plus, être sélectif : s'il y a plus d'un conducteur, le signal mesuré doit dépendre principalement du conducteur qui est contrôlé, la contribution due aux autres conducteurs étant inférieure à 10%.

### EXPOSÉ DE L'INVENTION

L'invention concerne un dispositif capacitif de mesure de la tension d'un élément à haute tension comprenant une surface conductrice dirigée vers cet élément à haute tension et comprenant au moins deux secteurs conducteurs séparés connectés en parallèle au moyen d'au moins un câble de sortie à des moyens de signalisation et de contrôle, caractérisé en ce qu'il comprend :
- une première couche conductrice relié au potentiel de terre,
- une seconde couche isolante,
- une troisième couche formée d'au moins deux secteurs conducteurs séparés,
- au moins un pont de contact permettant la connexion d'au moins un secteur à un câble de sortie.

Avantageusement, ce dispositif a une forme allongée de longueur approximativement égale à deux fois la largeur.

Avantageusement, chaque secteur comporte un point de soudure permettant de connecter celui-ci à l'un des deux ponts de contact reliés chacun à un câble de sortie.

Dans un mode de réalisation avantageux, la première couche comprend une couche mise à la terre de large surface, un premier pont de contact et un second pont de contact, la zone de surface des ponts de contact étant typiquement inférieure à la zone de la couche mise à la terre, chaque pont de contact étant connecté à au moins un des secteurs conducteurs de la troisième couche au travers d'un point de soudure, le nombre de secteurs ainsi connectés définissantt la dimension de la surface active.

Dans un autre mode de réalisation avantageux, le dispositif comprend un trou dans son centre de manière à laisser passer un contact mobile. La troisième couche présente deux secteurs séparés, qui sont étendus uniformément sur la surface du dispositif, la première couche couvrant toute la surface à l'exception d'une zone utilisée pour les ponts de contact séparés, chaque pont de contact étant connecté d'une part à l'un des secteurs et d'autre part, à un câble de sortie, le dispositif complet étant recouvert partiellement par une finition de protection, sauf sur une zone appelée secteur de contact.

L'invention concerne également un système de mesure de la tension d'un élément haute tension comportant au moins deux dispositifs tels que définis ci-dessus comprenant chacun une surface conductrice, formée de deux secteurs conducteurs séparés, dirigée vers cet élément haute tension, chaque secteur étant relié à un équipement de contrôle au travers d'un pont de contact et d'un câble de sortie.

Avantageusement, l'équipement de contrôle comprend un moyen indicateur qui délivre un signal optique si la tension du conducteur est supérieure à une première valeur déterminée, ce moyen indicateur étant alimenté uniquement par le dispositif. L'équipement de contrôle peut également comprendre un second moyen indicateur qui délivre un signal électrique et/ou optique si la tension est inférieure à une seconde valeur déterminée.

L'invention concerne également un poste électrique isolé au gaz mettant en oeuvre au moins un dispositif, tel que défini ci-dessus, qui est connecté à des moyens de signalisation et de contrôle.

Dans un premier exemple de mise en oeuvre, ce poste est un poste triphasé comprenant trois conducteurs agencés en triangle, le dispositif de l'invention étant disposé à l'intérieur de l'enceinte de celui-ci avec son axe longitudinal parallèle aux conducteurs.

Dans un second exemple de mise en oeuvre, le poste est un poste triphasé comprenant trois conducteurs agencés dans un plan, le dispositif de l'invention étant disposé dans la prolongation de l'axe d'un conducteur déterminé parmi les trois conducteurs, qui sont interrompus, avec son axe longitudinal perpendiculaire au plan de ces conducteurs, et coupant l'axe de ce conducteur déterminé.

Avantageusement, ce poste électrique comprend, pour chaque conducteur, un contact terre fixe fixé sur une plaque de montage connectée à la terre, un contact haute tension fixe monté dans un carter de contact fixé de manière rigide à la plaque de montage, ces deux contacts étant munis d'une cavité interne et un contact mobile en forme de barre, les contacts fixes agissant par une force de contact de ressort sur le contact mobile, le contact mobile étant apte à coulisser dans le contact terre fixe et à pénétrer dans le contact haute tension fixe et ainsi connecter le contact haute tension fixe au contact terre fixe et donc à la plaque de montage.

Avantageusement, la plaque de montage possède trois trous, un pour chaque phase, disposés dans un plan perpendiculaire à celle ci, un premier évidement qui traverse les trois trous commutateurs, ce premier évidement laissant de la place pour le positionnement d'au moins un dispositif et étant approximativement deux fois plus profond que l'épaisseur de celui-ci, un second évidement, qui est de forme rectangulaire, qui traverse un trou commutateur et a une épaisseur égale, ou légèrement supérieure, à l'épaisseur du dispositif, la longueur et la largeur du second évidement étant telles qu'un dispositif peut prendre place à l'intérieur de celui-ci, un troisième évidement, en forme de canal, réalisé du côté allongé du premier évidement afin de laisser paser les câbles de sortie.

Avantageusement, le poste électrique comprend une plaque de recouvrement qui possède une ouverture pour chaque phase, utilisée pour optimiser le champ électrique, et disposée sous la plaque de montage.

Dans un mode de réalisation avantageux, ce poste est un commutateur de mise à la terre.

L'invention présente notamment les avantages suivants :
- La structure du dispositif de l'invention, et en particulier la forme oblongue du circuit imprimé avec des secteurs indépendants, permet une redondance des informations.
- La forme oblongue permet de diminuer la distorsion du signal de mesure pour une utilisation particulière dans un poste GIS triphasé c'est-à-dire dont les trois phases sont contenues dans une même enveloppe métallique.
- Différentes implantations particulières du dispositif de l'invention sont possibles dans un poste GIS grâce à son encombrement réduit et sa forme.
- Le dispositif de l'invention peut alimenter un affichage sans apport d'énergie extérieure.

Le dispositif de l'invention présente, en outre, les avantages suivants :
- une mise au point simple ;
- un faible coût,
- un espace requis minimal,
- une application flexible,
- une possibilité aisée de redondance,
- une adaptation du taux de transmission en réalisant un simple changement sur la carte de circuit imprimé,
- une application aisée à un commutateur de mise à la terre, aucun espace supplémentaire n'étant alors nécessaire.

### BRÈVE DESCRIPTION DES DESSINS

La figure 1 illustre le dispositif capacitif de mesure de l'invention.
La figure 2 illustre un premier exemple de mise en oeuvre du dispositif de l'invention, dans lequel celui-ci est disposé dans une cavité d'un poste électrique isolé au gaz contenant trois conducteurs haute tension disposés en triangle.
La figure 3 illustre un exemple de réalisation du dispositif de l'invention, avec une troisième couche comportant huit secteurs séparés.
Les figures 4, 5 et 6 illustrent un exemple de mise en oeuvre du dispositif de l'invention dans un poste électrique isolé au gaz de type commutateur de mise à la terre.
Les figures 7 et 8, et 9 et 10 illustrent un autre exemple de réalisation du dispositif de l'invention, et sa mise en oeuvre dans un commutateur de mise à la terre tel qu'illustré sur les figures 4, 5 et 6.
La figure 11 illustre le système de mesure de l'invention avec un moyen d'indication d'auto-alimentation locale et une unité de détection de tension à distance.
La figure 12 illustre le système de mesure de l'invention avec deux unités de détection de tension redondantes à distance.

### EXPOSÉ DÉTAILLÉ DE MODES DE RÉALISATION PARTICULIERS

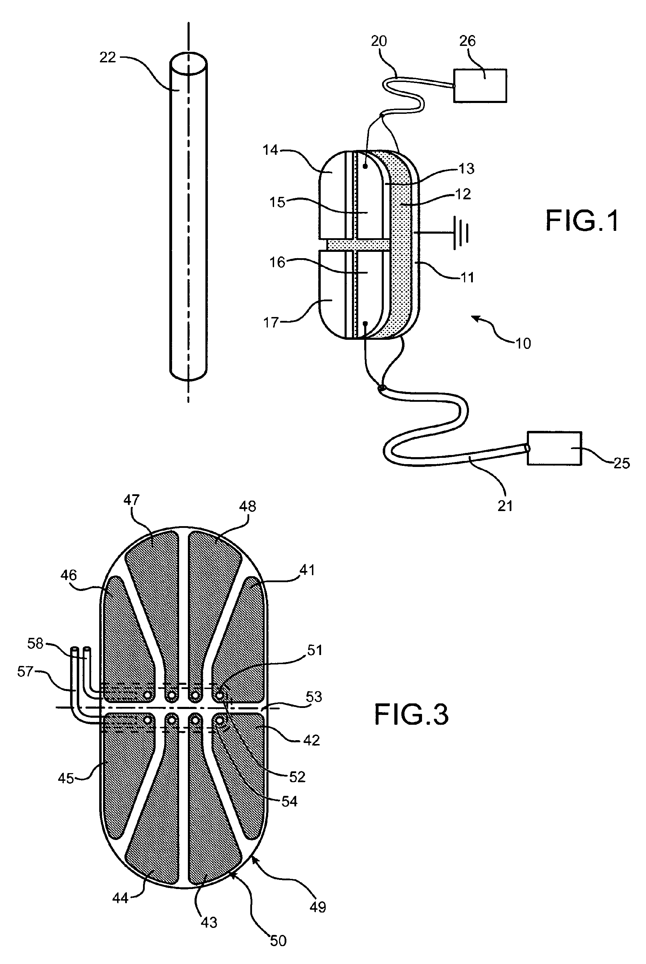

Le dispositif de l'invention 10, illustré sur la figure 1, comprend une carte en circuit imprimé, qui comporte trois couches :
- une première couche 11 qui est une couche conductrice,
- une seconde couche 12 réalisée en un matériau isolant, de préférence de l'époxy puisque celui-ci est disponible avec une grande précision d'épaisseur,
- une troisième couche 13, qui est une couche conductrice.

La troisième couche 13 comprend plusieurs secteurs isolés, par exemple quatre secteurs 14, 15, 16 et 17 comme illustré sur la figure 1, qui sont prévus pour être connectés à au moins l'un des deux câbles de sortie de signal 20 et 21.

La première couche 11 est normalement connectée au potentiel de la terre. La troisième couche 13 est dirigée vers une électrode haute tension 22, par exemple un conducteur haute tension dont on veut mesurer la tension. La troisième couche 13 est branchée sur un niveau de tension de quelques volts au-dessus du potentiel de la terre dus à l'influence du champ électrique généré par l'électrode haute tension 22.

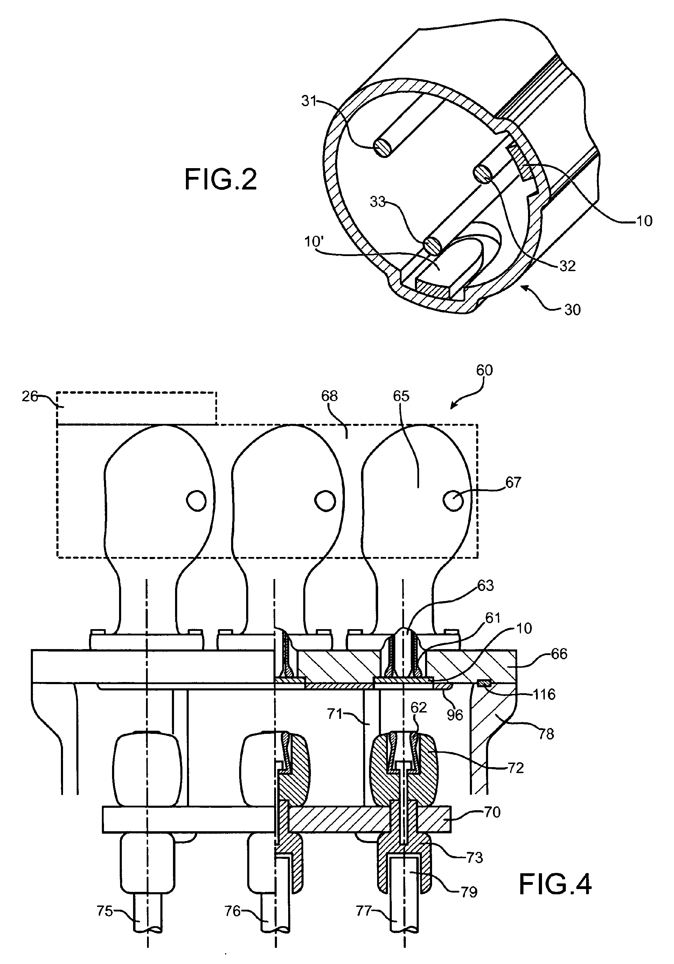

Le dispositif de l'invention 10 comporte deux câbles de sortie de signal 20 et 21 qui permettent une connexion à un équipement de détection, par exemple un équipement de contrôle 25 et un affichage lumineux 26. L'équipement de contrôle 25 peut ainsi prendre des décisions logiques, par exemple bloquer un commutateur de mise à la terre, ou un déconnecteur, si une tension est détectée. L'affichage 26 est un affichage optique, par exemple à un tube a décharge avec un circuit électrique, permettant de délivrer des informations à un opérateur. L'affichage peut être fixé à l'actionneur 68 d'un commutateur de mise à la terre, comme illustré sur la figure 4.

Le dispositif de l'invention 10 est de forme allongée. De manière typique sa longueur est égale à 2 fois sa largeur. Son axe longitudinal, correspondant à sa longueur, est disposé en parallèle à l'axe du conducteur 22 à contrôler. Ainsi, avantageusement, le signal transmis à partir de conducteurs parallèles véhiculant d'autres phases est réduit à moins de 10% du signal transmis à partir du conducteur à contrôler.

Le dispositif de l'invention peut être adapté à des systèmes de détection de tension selon la norme IEC 61243-5, ce qui signifie qu'il peut être adapté pour fournir un courant de 2 microampères pour une tension de 90 volts, mais aussi pour fournir un courant de 0,67 microampère pour une tension de 4 volts si le conducteur 22 auquel ce dispositif appartient est traversé par un courant pour une tension nominale. Une amplification n'est pas nécessaire. Mais la tension induite par un conducteur parcouru par un courant disposé à proximité du conducteur auquel le capteur appartient est inférieure à une valeur de seuil du système de détection de tension.

Si le conducteur de phase concerné est à une tension nominale, le dispositif doit fournir une valeur de sortie de 1 à 2 fois les valeurs de seuil. La surface du dispositif est adaptée en conséquence.

Dans un premier mode de mise en oeuvre, illustré sur la figure 2, le dispositif de l'invention 10 (10') peut être fixé à la surface interne de l'enceinte 30 d'un poste isolé au gaz (GIS) contenant trois conducteurs 31, 32 et 33, faisant saillie de celle-ci. Il peut également être placé dans une cavité prévue dans l'encapsulation, comme illustré sur la figure 2. Dans un mode de réalisation avantageux illustré sur la figure 4, il peut être fixé à proximité d'un contact de terre sur une plaque de montage 66 d'un commutateur de mise à la terre.

La figure 3 illustre un autre exemple de réalisation du dispositif selon l'invention, dans lequel la troisième couche 50 comprend huit secteurs 41 à 48 séparés les uns des autres. Sur la figure 3, la première couche 49 est dessinée bien qu'elle ne soit pas visible, une seconde couche isolante étant disposée entre cette première (49) et cette troisième (50) couche.

Chaque secteur, par exemple 41, comporte un point de soudure, par exemple 51, permettant de connecter celui-ci à un pont de contact 52 ou 54.

La première couche 49 comprend une couche 53 mise à la terre de large surface, un premier pont de contact 52 et un second pont de contact 54. La zone de surface des ponts de contact 52 et 54 est typiquement inférieure à la zone de la couche mise à la terre. Chacun des deux câbles de sortie 57 et 58 est connecté à l'un des ponts de contact 52 et 54. Chacun des ponts de contact 52 et 54 est connecté à au moins un des secteurs 41 à 48 au travers d'un point de soudure 51, dépendant de l'application spécifique du capteur. Le nombre de secteurs 41 à 48 ainsi connectés définit la dimension de la surface active.

Au lieu de connecter des secteurs plus ou moins nombreux au pont de contact, des dispositifs prédéfinis avec seulement deux secteurs (pour permettre une redondance) et de même dimension allongée mais avec des zones différentes de secteurs peuvent être utilisés. On peut alors obtenir un dispositif capacitif de mesure adaptable aisément en ce qui concerne sa surface et donc son rapport de transmission.

Dans un exemple de mise en oeuvre avantageux, illustré sur la figure 4, un tel dispositif est fixé sur un poste isolé au gaz (GIS) triphasé de type commutateur de mise à la terre et est utilisé pour bloquer ou relâcher le fonctionnement de fermeture de ce commutateur. De manière similaire, il pourrait également être fixé à un commutateur de déconnexion et bloquer et relâcher le fonctionnement de celui-ci. Le dispositif de l'invention pourrait également être positionné dans un poste isolé au gaz à une seule phase.

Comme illustré sur la figure 4, les trois conducteurs 75, 76 et 77, correspondant aux trois phases, sont disposés dans un plan, de manière différente à celle illustrée sur la figure 2, où les conducteurs phases sont disposés en triangle. Dans la suite, on décrit l'agencement correspondant à une phase, les deux autres phases comportant un agencement similaire. L'agencement d'un commutateur de mise à la terre est bien connu de l'homme du métier. Par contre, l'introduction du dispositif de l'invention dans celui-ci est originale. Le commutateur de mise à la terre 60 comprend un contact terre fixe en forme de tulipe 61, un contact haute tension fixe en forme de tulipe 62 et un contact mobile en forme de barre 63. Les contacts en forme de tulipe agissent avec une force de contact de ressort sur le contact mobile 63. Un mécanisme avec carter 65 est fixé hermétiquement sur une plaque de montage 66. Ce mécanisme 65 transforme la rotation d'un arbre de commande 67, piloté par un actionneur 68, en un mouvement de translation du contact mobile 63. Le contact mobile 63 peut pénétrer dans le contact haute tension fixe 62 et ainsi connecter le contact haute tension fixe 62 au contact terre fixe 61 et donc à la plaque de montage 66 qui est connectée à la terre. Un support isolant 70 est fixé sur la plaque de montage 66 par quatre tiges de fixation 71. Un carter de contact 72 est fixé à un connecteur 73 par un écrou. Le carter de contact 72 et le connecteur 73 sont ainsi fixés au support isolant 70. Le contact haute tension fixe 62 est monté dans le carter de contact 72. Ainsi, le contact haute tension fixe 62 est fixé de manière rigide à la plaque de montage 66. Le dispositif de l'invention 10 est monté sur la plaque de montage 66 près du contact terre fixe 61.

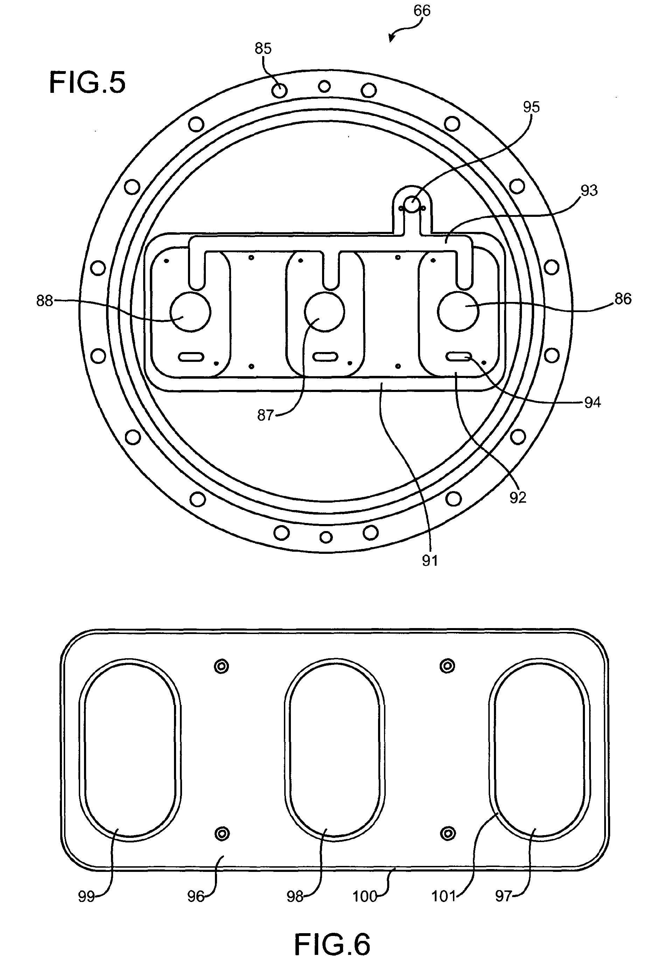

L'axe longitudinal du dispositif de l'invention est disposé de manière perpendiculaire au plan dans lequel les conducteurs 75, 76 et 77 sont disposés. Le dispositif de l'invention 10 est disposé dans la prolongation du conducteur à contrôler, ici le conducteur 77, de telle manière que son axe longitudinal croise l'axe de ce conducteur 77. Le dispositif de l'invention est de forme allongée. Sa longueur est approximativement égale à deux fois sa largeur. Son axe longitudinal est disposé perpendiculairement au plan des conducteurs 75, 76 et 77 (voir figures 5 et 6). Le signal transmis à partir d'un des deux autres conducteurs parallèles au conducteur à surveiller est ainsi réduit à moins de 10% du signal mesuré.

Le commutateur de mise à la terre complet 60 est préassemblé sur la plaque de montage 66, puis l'assemblage ainsi réalisé est fixé hermétiquement sur un boîtier 78, le connecteur 73, qui est équipé avec au moins un contact à ressort 79, étant branché au même moment sur le conducteur haute tension 77. Le dispositif de l'invention 10 est connecté à l'affichage 26, qui peut être fixé sur le carter de l'actionneur 68, par un câble de sortie.

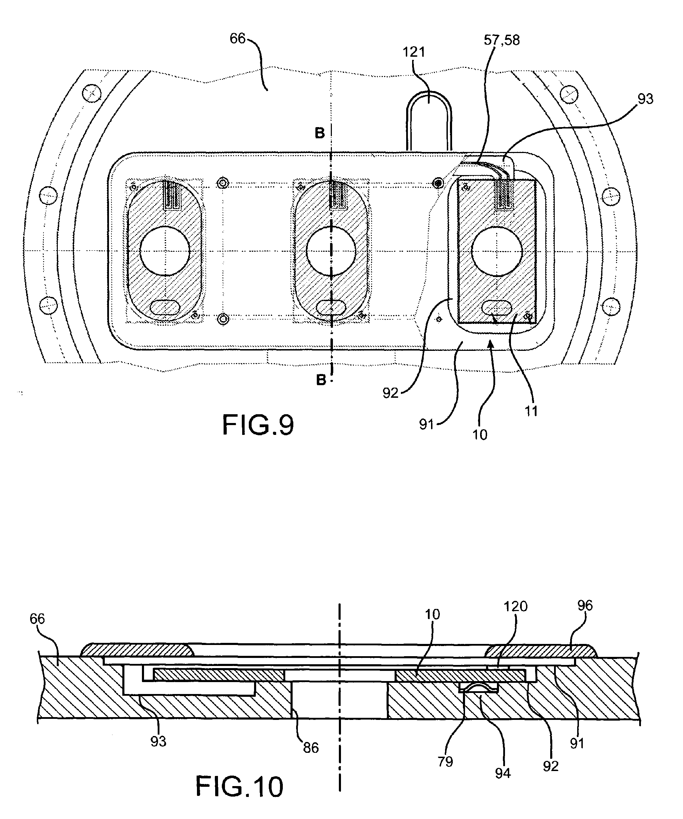

Comme illustré sur la figure 5, la plaque de montage 66 comprend un ensemble de trous de fixation 85 pour la fixation de cette plaque 66 au boîtier 78. Elle est également adaptée à des moyens d'étanchéification bien connus de l'homme de l'art, non représentés sur la figure. Cette plaque de montage 66 possède trois trous 86, 87 et 88, un pour chaque phase, disposés dans un plan perpendiculaire à la plaque de montage 66 pour permettre la commutation. Un premier évidement 91 traverse ces trois trous 86, 87 et 88, est approximativement deux fois plus profond que l'épaisseur du dispositif de l'invention 10 et laisse ainsi de la place pour le positionnement de celui-ci. Un second évidement 92, qui est de forme rectangulaire, traverse le trou 86 et a une épaisseur égale, ou légèrement supérieure, à l'épaisseur du dispositif de l'invention. La longueur et la largeur de ce second évidement 92 sont telles que le dispositif de l'invention 10 peut prendre place à l'intérieur de celui-ci, comme illustré sur la figure 10. Un troisième évidement 93, en forme de canal, est réalisé du côté allongé du premier évidement 91 afin de laisser passer les câbles de sortie. Le troisième évidement 93 se termine dans un trou de passage 95 auquel un raccord étanche est fixé pour serrer hermétiquement les câbles de sortie. Un quatrième évidement 94 disposé du côté opposé au troisième évidement 93 est réalisé pour supporter un contact à ressort.

La figure 6 illustre une plaque de recouvrement 96 qui possède une ouverture 97 (98, 99) pour chaque phase. Les bords sont arrondis avec un rayon 100, 101 qui est approximativement égal à l'épaisseur de cette plaque de recouvrement 96. Cette plaque utilisée pour optimiser le champ électrique (pour éviter des concentrations de champ), est disposée sous la plaque de montage 66, comme illustré sur la figure 4.

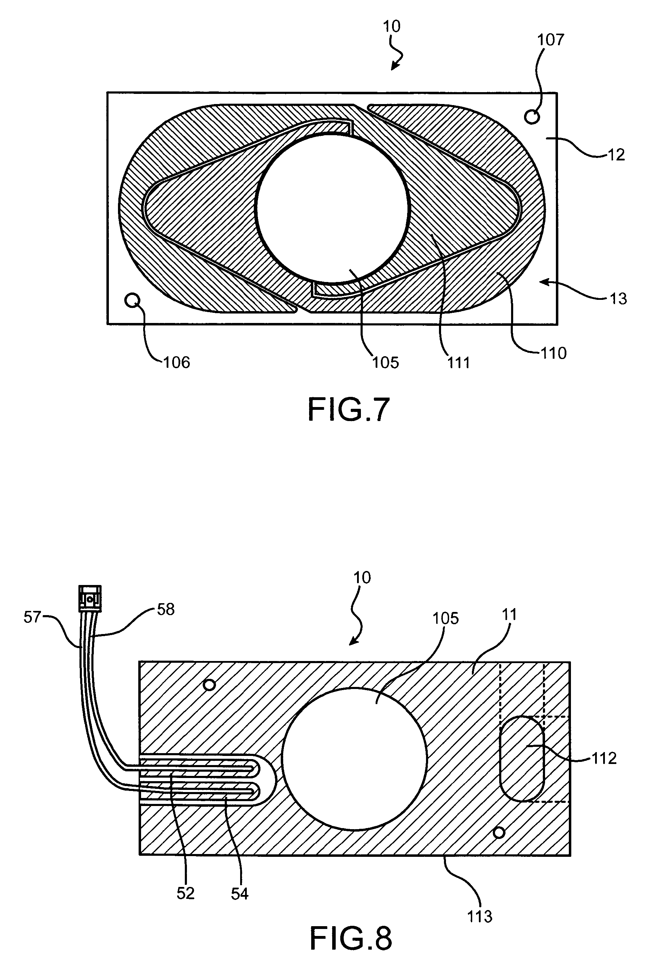

Dans un exemple de réalisation du dispositif 10, illustré, respectivement dans une vue de dessus et une vue de dessous, sur les figures 7 et 8, le dispositif de l'invention possède un trou 105 dans son centre qui permet de laisser passer le contact mobile 63. Les deux trous de fixation 106 et 107 sont utilisés pour la fixation du dispositif de l'invention 10 sur la plaque de montage 66. La troisième couche 13 présente deux secteurs 110, 111 séparés. Ces deux secteurs sont étendus uniformément sur la surface du dispositif de l'invention 10. La première couche 11 couvre toute la surface à l'exception d'une zone utilisée pour les ponts de contact séparés 52 et 54. Chaque pont de contact 52 et 54 est connecté d'une part à l'un des secteurs 110 comme illustré sur la figure 3, et d'autre part, à un câble de sortie. Le dispositif de l'invention complet est recouvert par une finition de protection 113 sauf sur une zone qui est appelée secteur de contact 112, qui est utilisée pour faire contact avec le contact à ressort. Cette finition de protection a pour objet de protéger le dispositif de l'invention d'une dégradation due à des gaz agressifs. La forme des secteurs 110 et 111 est optimisée pour avoir le même taux de transmission à partir du conducteur à contrôler 77 vers le secteur 110 et le secteur 111 respectivement. Les deux secteurs 110 et 111 sont disposés dans l'espace supérieur et l'espace inférieur par rapport au plan des trois conducteurs 75, 76 et 77. Le signal généré au niveau des deux secteurs 110 et 111 est le même, ce qui rend possible l'utilisation de deux secteurs redondants dans des détecteurs identiques.

Les figures 9 et 10 illustrent, respectivement dans une vue de dessus et dans une vue en coupe, un contact à ressort 79, disposé dans le quatrième évidement 94, qui réalise le contact de la plaque de montage 66, qui est au potentiel de la terre, à la première couche 11 du dispositif de l'invention 10 dans le secteur de contact 112. Le dispositif de l'invention 10 avec les câbles 57 et 58 est disposé dans le second évidement 92 et le troisième évidement 93. Le dispositif de l'invention 10 est fixé a la plaque de montage 66 par des rivets 120, passant par les trous 106, 107. La plaque de recouvrement 96 est fixée à la plaque de montage 66 et est ainsi connectés au potentiel de terre. La troisième couche 13 ne touche, en aucun endroit, le potentiel de terre et est donc libre de prendre un potentiel donné fonction de l'amplitude du champ électrique environnant.

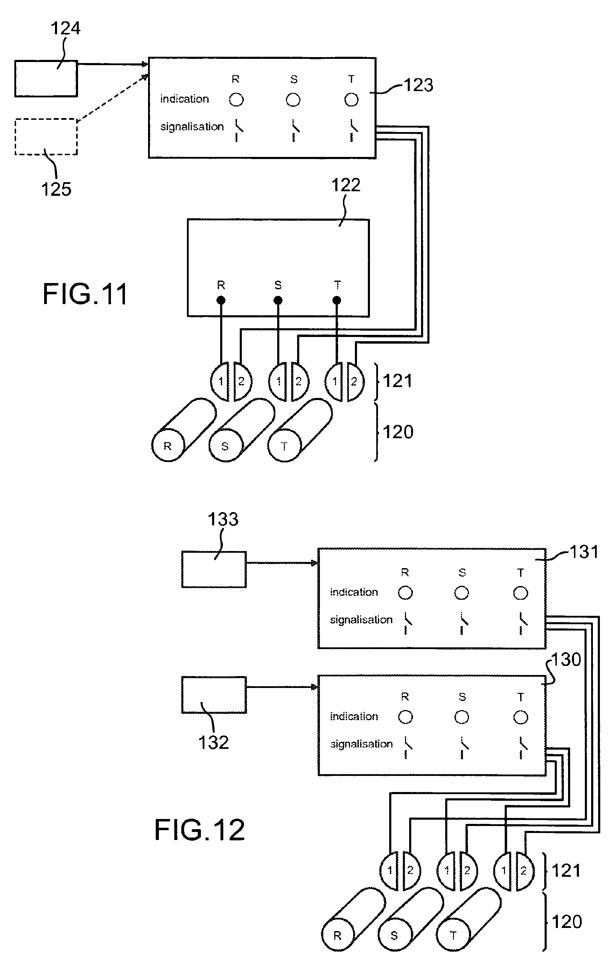

Les figures 11 et 12 montrent des possibilités de réaliser un système redondant triphasé haute tension avec trois câbles R, S et T 120 selon l'invention. On décrit ici un tel système pour une phase seulement, l'agencement pour les autres phases étant similaire.

Dans la première variante illustrée sur la figure 11, un secteur 1 (121) du dispositif de l'invention est connecté à une première unité de détection de tension 122. Cette unité 122 est située près de l'équipement de fonctionnement manuel et délivre un signal optique à l'opérateur si le conducteur de la phase est énergisé. Ce système est auto-alimenté, ce qui signifie qu'il est actionné par le courant fourni par le dispositif de l'invention. Il ne nécessite pas d'alimentation supplémentaire. L'indicateur optique peut être un tube a décharge avec un circuit électrique travaillant à 0,5 microampères - 3 microampères. Un secteur 2 (121) du dispositif de l'invention est connecté à une unité de détection de tension classique 123. Cette unité est alimentée par une batterie 124, ou, comme ici, deux batteries 124 et 125 pour des raisons de sécurité. Cette unité de détection de tension 124 délivre un signal optique et électrique « aucune tension » si la tension est inférieure à une limite déterminée.

Dans une seconde variante illustrée sur la figure 12, les deux secteurs 1 et 2 du dispositif de l'invention sont connectés chacun à une unité de détection de tension « classique » 130 et 131, alimentée chacune respectivement par une batterie 132 ou 133. Si l'une des deux ne fonctionne plus, la seconde peut continuer à fonctionner correctement.

### REFERENCES

[1] EP 1 431 767
[2] US 6,333,715 ou EP 0 984 289

## Revendications

1. Dispositif capacitif de mesure de la tension d'un élément à haute tension (22) comprenant une surface conductrice dirigée vers cet élément à haute tension et comprenant au moins deux secteurs conducteurs séparés (14, 15, 16, 17) aptes à être connectés en parallèle à des moyens de signalisation et de contrôle (25, 26) au moyen d'au moins un câble de sortie, **caractérisé en ce qu'**il comprend :
- une première couche conductrice (11) reliée au potentiel de terre,
- une seconde couche isolante (12),
- une troisième couche (13) formée d'au moins deux secteurs conducteurs séparés,
- au moins un pont de contact permettant la connexion d'au moins un secteur à un câble de sortie.

2. Dispositif selon la revendication 1, qui a une forme allongée de longueur approximativement égale à deux fois la largeur.

3. Dispositif selon la revendication 1, dans lequel chaque secteur (41-48) comporte un point de soudure (51) permettant de connecter celui-ci à l'un des deux ponts de contact (52, 54) reliés chacun à un câble de sortie (57, 58).

4. Dispositif selon la revendication 3, dans lequel la première couche (49) comprend une couche (53) mise à la terre de large surface, un premier pont de contact (52) et un second pont de contact (54), la zone de surface des ponts de contact (52 et 54) étant typiquement inférieure à la zone de la couche mise à la terre, chaque pont de contact (52 et 54) étant connecté à au moins un des secteurs conducteurs de la troisième couche (41 à 48) au travers d'un point de soudure (51), le nombre de secteurs (41 à 48) ainsi connectés définissant la dimension de la surface active.

5. Dispositif selon la revendication 1, qui comprend un trou dans son centre de manière à laisser passer un contact mobile (63).

6. Dispositif selon la revendication 5, dans lequel la troisième couche (13) présente deux secteurs (110, 111) séparés qui sont étendus uniformément sur la surface du dispositif, la première couche (11) couvrant toute la surface à l'exception d'une zone utilisée pour les ponts de contact séparés (52 et 54), chaque pont de contact étant connecté d'une part à l'un des secteurs (110, 111) et d'autre part à un câble de sortie, le dispositif étant recouvert partiellement par une finition de protection (113).

7. Système de mesure de la tension d'un élément haute tension comprenant au moins deux dispositifs selon l'une quelconque des revendications précédentes, dans lequel chaque dispositif comprend une surface conductrice, formée de deux secteurs conducteurs séparés, dirigée vers cet élément haute tension, chaque secteur étant relié à un équipement de contrôle au travers d'un pont de contact et d'un câble de sortie.

8. Système de mesure selon la revendication 7, dans lequel l'équipement de contrôle comprend un moyen indicateur qui délivre un signal optique si la tension de l'élément haute tension est supérieure à une première valeur déterminée, ce moyen indicateur étant alimenté uniquement par un dispositif.

9. Système selon la revendication 8, dans lequel l'équipement de contrôle comprend un second moyen indicateur qui délivre un signal électrique et/ou optique si la tension est inférieure à une seconde valeur déterminée.

10. Poste électrique isolé au gaz mettant en oeuvre au moins un dispositif selon l'une quelconque des revendications 1 à 6, connecté à des moyens de signalisation et de contrôle (25, 26).

11. Poste électrique selon la revendication 10, comprenant trois conducteurs (31,32, 33) agencés en triangle, dans lequel le dispositif est disposé à l'intérieur de l'enceinte 30 de celui-ci avec son axe longitudinal parallèle aux conducteurs.

12. Poste électrique selon la revendication 10, comprenant trois conducteurs (75, 76, 77) agencés dans un plan, dans lequel le dispositif est disposé dans la continuation de l'axe d'un conducteur déterminé des conducteurs qui sont interrompus, avec son axe longitudinal perpendiculaire au plan des conducteurs, et coupant l'axe de ce conducteur déterminé.

13. Poste électrique selon la revendication 12, qui comprend, pour chaque conducteur, un contact terre fixe (61) fixé sur une plaque de montage (66) connectée à la terre, un contact haute tension fixe (62) monté dans un carter de contact (72) fixé de manière rigide à la plaque de montage (66), ces deux contacts étant munis d'une cavité interne, et un contact mobile en forme de barre (63), les contacts fixes (61, 62) agissant par une force de contact de ressort sur le contact mobile (63), le contact mobile (63) étant apte à coulisser dans le contact terre fixe (61) et à pénétrer dans le contact haute tension fixe (62) et ainsi connecter le contact haute tension fixe (62) au contact terre fixe (61) et donc à la plaque de montage (66).

14. Poste électrique selon la revendication 13, dans lequel la plaque de montage (66) possède trois trous (86, 87 et 88), un pour chaque phase, disposés dans un plan perpendiculaire à celle-ci (66), un premier évidement (91) qui traverse les trois trous commutateurs (86, 87 et 88), ce premier évidement (91) laissant de la place pour le positionnement d'au moins un dispositif (10) et étant approximativement deux fois plus profond que l'épaisseur de celui-ci, un second évidement (92), qui est de forme rectangulaire, qui traverse le trou commutateur (86) et a une épaisseur égale, ou légèrement supérieure, à l'épaisseur du dispositif, la longueur et la largeur du second évidement (92) étant telles qu'un dispositif (10) peut prendre place à l'intérieur de celui-ci, un troisième évidement (93), en forme de canal, réalisé du côté allongé du premier évidement (91) afin de laisser passer les câbles de sortie.

15. Poste électrique selon la revendication 14, qui comprend une plaque de recouvrement (96) qui possède une ouverture (97, 98, 99) pour chaque phase, utilisée pour optimiser le champ électrique, et disposée sous la plaque de montage (66).

16. Poste électrique selon l'une quelconque des revendications 10 à 15 qui permet une commutation avec mise à la terre.

## Claims

1. A capacitive device for measuring the voltage of a high-voltage element (22), the device having a conductive surface facing towards said high-voltage element, the conductive surface consisting of at least two separate conductive segments (14, 15, 16, 17) that are adapted to be connected in parallel to indicator and control means (25, 26) through at least one output cable, the device being **characterized in that** it comprises:
• a conductive first layer (11) connected to ground potential;
• an insulating second layer (12);
• a third layer (13) consisting of at least two separate conductive sectors; and
• at least one bridge contact element for permitting at least one sector to be connected to an output cable.

2. A device according to claim 1, that is of elongate shape, having a length approximately equal to twice its width.

3. A device according to claim 1, wherein each sector (41-48) has a soldering point for connection of the sector concerned to one of the two bridge contact elements (52, 54), each of which is connected to an output cable (57, 58).

4. A device according to claim 3, wherein the first layer (49) comprises a grounded layer (53) having a wide surface, a first bridge contact element (52) and a second bridge contact element (54), the surface area of the bridge contact elements (52 and 54) typically being smaller than the surface area of the grounded layer, each bridge contact element (52 and 54) being connected to at least one of the conductive segments (41 to 48) of the third layer through a soldering point (51), the number of sectors (41 to 48) thereby connected defining the size of the active surface.

5. A device according to claim 1, having a hole in its center such as to enable a movable contact (63) to pass through.

6. A device according to claim 5, wherein the third layer (13) has two separate sectors (110, 111) that are extended uniformly over the surface of the device, the first layer (11) covering the whole surface with the exception of an area that is used for the separate bridge contact elements (52 and 54), each bridge contact element being connected, firstly, to one of said sectors (110, 111) of the third layer, and secondly to an output cable, the device being partly covered with a protective finish (113).

7. A measuring system for measuring the voltage in a high-voltage element, the system comprising at least two devices according to any preceding claim, wherein each said device has a conductive surface consisting of two separate conductive sectors, which surface faces towards said high-voltage element, each said sector being connected to control equipment through a bridge contact element and an output cable.

8. A measuring system according to claim 7, wherein the control equipment includes indicator means for delivering an optical signal if the voltage in said high-voltage element is greater than a predetermined first value, the indicator means being supplied with power solely through a said device.

9. A system according to claim 8, wherein the control equipment includes a second indicator means for delivering an electrical and/or optical signal if the voltage is lower than a predetermined second value.

10. A gas-insulated substation adapted to make use of a device according to any one of claims 1 to 6, when connected to indicator and control means (25, 26).

11. A substation according to claim 10, including three conductor s (31, 32, 33) connected in delta formation, wherein said device is disposed inside the gas chamber (30) of the substation, with its longitudinal axis parallel to the conductors.

12. A substation according to claim 10, including three conductors (75, 76, 77) disposed in one plane, wherein said device is disposed in the continuation of the axis of a predetermined one of the conductors, which conductors are interrupted, with its longitudinal axis at right angles to the plane of the conductors, and intersecting the axis of said predetermined conductor.

13. A substation according to claim 12 that includes, for each said conductor, a fixed ground contact (61) that is fastened on a mounting plate (66) connected to the ground, a fixed high-voltage contact (62) that is mounted in a contact housing (72) fastened rigidly to the mounting plate (66), the two said contacts having an internal cavity, and a movable contact in the form of a bar (63), with the fixed contacts (61, 62) acting on the movable contact (63) with a spring contact force, the movable contact (63) being adapted to slide in the fixed ground contact (61) and to penetrate into the fixed high-voltage contact (62), so as to connect the fixed high-voltage contact (62) to the fixed ground contact (61) and therefore also to the mounting plate (66) .

14. A substation according to claim 13, wherein the mounting plate (66) has three switch holes (86, 87 and 88), one for each phase, disposed in a plane at right angles to the mounting plate (66), a first recess (91) that extends across the three switch holes (86, 87 and 88), the first recess (91) providing space for at least one said device (10) therein and being of a depth that is approximately twice the thickness of said at least one device, a second recess (92) that is rectangular and extends across the switch hole (86), the second recess being of thickness that is equal to or slightly greater than the thickness of said device, the length and width of the second recess (92) being such that a said device (10) can be positioned inside the second recess, and a third recess (93) in the form of a channel, formed on the long side of the first recess (91) so as to accommodate the output cables.

15. A substation according to claim 14, further including a cover plate (96) having one aperture (97, 98, 99) for each phase, which plate is used for the purpose of optimizing the electric field, being disposed underneath the mounting plate (66).

16. A substation according to any one of claims 10 to 15 for switching to ground.

## Patentansprüche

1. Kapazitive Spannungsmessvorrichtung für ein Hochspannungselement (22), enthaltend eine leitfähige Fläche, die diesem Hochspannungselement zugewandt ist und zumindest zwei separate leitfähige Abschnitte (14, 15, 16, 17) aufweist, die über zumindest ein Ausgangskabel mit Melde- und Kontrollmitteln (25, 26) parallel verbunden werden können, **dadurch gekennzeichnet, dass** sie aufweist:
- eine leitfähige erste Schicht (11), die mit dem Erdpotential verbunden ist,
- eine isolierende zweite Schicht (12),
- eine dritte Schicht (13), die aus zumindest zwei separaten leitfähigen Abschnitten gebildet ist,
- zumindest eine Kontaktbrücke, welche die Verbindung zumindest eines Abschnitts mit einem Ausgangskabel gestattet.

2. Vorrichtung nach Anspruch 1, wobei sie eine längliche Form mit einer Länge annähernd gleich der zweifachen Breite hat.

3. Vorrichtung nach Anspruch 1, wobei jeder Abschnitt (41 - 48) einen Lötpunkt (51) aufweist, über welchen dieser mit einer der beiden Kontaktbrücken (52, 54) verbunden werden kann, die jeweils mit einem Ausgangskabel (57, 58) verbunden sind.

4. Vorrichtung nach Anspruch 3, wobei die erste Schicht (49) eine geerdete Schutzschicht (53) mit breiter Fläche, eine erste Kontaktbrücke (52) und eine zweite Kontaktbrücke (54) aufweist, wobei der Oberflächenbereich der Kontaktbrücken (52, 54) typischerweise kleiner als der Bereich der geerdeten Schutzschicht ist, wobei jede Kontaktbrücke (52 und 54) über einen Lötpunkt (51) mit zumindest einem der leitfähigen Abschnitte der dritten Schicht (41 bis 48) verbunden ist, wobei durch die Anzahl der so verbundenen Abschnitte (41 bis 48) die Abmessung der Wirkfläche bestimmt wird.

5. Vorrichtung nach Anspruch 1, wobei sie in ihrer Mitte zumindest eine Bohrung aufweist, so dass ein beweglicher Kontakt (63) durchtreten kann.

6. Vorrichtung nach Anspruch 5, wobei die dritte Schicht (13) zwei separate Abschnitte (110, 111) aufweist, die sich gleichmäßig über die Fläche der Vorrichtung erstrecken, wobei die erste Schicht (11) die gesamte Fläche bedeckt, abgesehen von einem Bereich, der für die separaten Kontaktbrücken (52 und 54) verwendet wird, wobei jede Kontaktbrücke einerseits mit dem einen Abschnitt (110, 111) und andererseits mit einem Ausgangskabel verbunden ist, wobei die Vorrichtung teilweise mit einem Schutzüberzug (113) bedeckt ist.

7. Spannungsmessgerät für ein Hochspannungselement, enthaltend zumindest zwei Vorrichtungen nach einem der vorangehenden Ansprüche, wobei jede Vorrichtung eine leitfähige Fläche aufweist, die aus zwei separaten, leitfähigen Abschnitten gebildet und diesem Hochspannungselement zugewandt ist, wobei jeder Abschnitt über eine Kontaktbrücke und einem Ausgangskabel mit einer Kontrolleinrichtung verbunden ist.

8. Messgerät nach Anspruch 7, wobei die Kontrolleinrichtung ein Anzeigemittel aufweist, das ein optisches Signal dann ausgibt, wenn die Spannung des Hochspannungselements höher als ein erster vorbestimmter Wert ist, wobei dieses Anzeigemittel nur über eine Vorrichtung gespeist wird.

9. Messgerät nach Anspruch 8, wobei die Kontrolleinrichtung ein zweites Anzeigemittel aufweist, das ein elektrisches und/oder optisches Signal dann ausgibt, wenn die Spannung kleiner als ein zweiter vorbestimmter Wert ist.

10. Gasisolierte Schaltanlage, bei der zumindest eine Vorrichtung nach einem der Ansprüche 1 bis 6 eingesetzt wird, die mit Melde- und Kontrollmitteln (25, 26) verbunden ist.

11. Schaltanlage nach Anspruch 10, enthaltend drei Leiter (31, 32, 33), die in Dreiecksform angeordnet sind, wobei die Vorrichtung innerhalb der Ummantelung (30) derselben angeordnet ist und mit der Längsachse parallel zu den Leitern verläuft.

12. Schaltanlage nach Anspruch 10, enthaltend drei Leiter (75, 76, 77), die in
einer Ebene angeordnet sind, wobei die Vorrichtung in Verlängerung der Achse eines bestimmten Leiters der unterbrochenen Leiter angeordnet ist mit ihrer Längsachse senkrecht zur Ebene der Leiter verläuft und die Achse dieses bestimmten Leiters schneidet.

13. Schaltanlage nach Anspruch 12, die für jeden Leiter einen festen
Erdungskontakt (61) aufweist, der an einer mit der Erde verbundenen Montageplatte (66) befestigt ist, sowie einen festen Hochspannungskontakt (62), der in einem Kontaktgehäuse (72) montiert ist, das in starrer Weise an der Montageplatte (66) befestigt ist, wobei diese beiden Kontakte mit einem Innenhohlraum versehen sind, sowie einen beweglichen Kontakt (63) in Stangenform, wobei die festen Kontakte (61, 62) mit einer Federkontaktkraft auf den beweglichen Kontakt (63) einwirken, wobei der bewegliche Kontakt (63) in den festen Erdungskontakt gleiten und in den festen Hochspannungskontakt (62) eindringen kann und damit den festen Hochspannungskontakt (62) mit den festen Erdungskontakt (61) und damit mit der Montageplatte (66) verbinden kann.

14. Schaltanlage nach Anspruch 13, wobei die Montageplatte (66) drei Bohrungen (86, 87 und 88) aufweist, für jede Phase eine, die in einer senkrecht zu dieser (66) verlaufenden Ebene angeordnet sind, sowie eine erste Ausnehmung (91), welche die drei Schalterbohrungen (86, 87, 88) durchsetzt, wobei diese erste Ausnehmung (91) Platz für das Positionieren zumindest einer Vorrichtung (10) freilässt und ungefähr doppelt so tief wie die Dicke derselben ist, eine zweite Ausnehmung (92) rechteckiger Form, welche durch die Schalterbohrung (86) tritt und eine Dicke gleich oder geringfügig größer als die Dicke der Vorrichtung hat, wobei die Länge und Breite der zweiten Ausnehmung (92) derart sind, dass eine Vorrichtung (10) in dieser Platz finden kann, eine dritte Ausnehmung (93) in Kanalform, die auf der Seite der Verlängerung der ersten Ausnehmung (91) ausgebildet ist, um die Ausgangskabel durchtreten zu lassen.

15. Schaltanlage nach Anspruch 14, enthaltend eine Abdeckplatte (96), welche eine Öffnung (97, 98, 99) für jede Phase aufweist, die zum Optimieren des elektrischen Feldes verwendet wird und unter der Montageplatte (66) angeordnet ist.

16. Schaltanalage nach einem der Ansprüche 10 bis 15, die einen Schaltvorgang mit Erdung gestattet.
